# FASCICULE DE BREVET EUROPEEN

(11) **EP 4 263 920 B1**
(45) Date de publication et mention de la délivrance du brevet: **16.04.2025**
(21) Numéro de dépôt: 21820632.4
(22) Date de dépôt: 07.12.2021
(51) Int. Cl.: C25D 5/10, C25D 5/12, C25D 7/00, G06K 19/077, H01L 23/498, H05K 3/24

(54) **PROCÉDÉ DE DÉPÔT D'UN ALLIAGE DE BRONZE SUR UN CIRCUIT IMPRIMÉ ET CIRCUIT IMPRIMÉ OBTENU PAR CE PROCÉDÉ**
VERFAHREN ZUR ABSCHEIDUNG EINER BRONZELEGIERUNG AUF EINER LEITERPLATTE UND MIT DIESEM VERFAHREN HERGESTELLTE LEITERPLATTE
METHOD FOR DEPOSITING A BRONZE ALLOY ON A PRINTED CIRCUIT AND PRINTED CIRCUIT OBTAINED BY SAID METHOD

(30) Priorité: 18.12.2020 FR 2013714
(43) Date de publication de la demande: 25.10.2023
(73) Titulaire: Linxens Holding, 78200 Mantes-la-Jolie (FR)
(72) Inventeur: SANSON, Jérôme, 78200 Mantes-La-Jolie (FR); COQUILLARD, Stéphanie, 78200 Mantes-La-Jolie (FR)
(74) Mandataire: INNOV-GROUP
(86) Numéro de dépôt international: PCT/EP2021/084523
(87) Numéro de publication internationale: WO 2022/128608

(56) Documents cités:
- EP-A1- 1 930 478
- EP-A1- 3 356 579
- EP-A2- 2 071 057
- CN-A- 111 534 840
- US-A1- 2013 236 742

## Description

### Domaine technique

L'invention concerne le domaine des circuits imprimés pour connecteurs ou antennes, par exemple pour des connecteurs et antennes de cartes à puce ou pour des dispositifs destinés à des applications médicales (ex. Détection du glucose dans le sang) ou pour la connexion des objets par internet (IoT ou « Internet of Things » en anglais).

### Etat de la technique

Par exemple, des circuits imprimés selon l'invention peuvent comporter des pistes conductrices et/ou des plages de contact électrique gravées dans un feuillet de matériau électriquement conducteur préalablement déposé sur un substrat diélectrique, ou bien des circuits comprenant une ou plusieurs grilles de connexion, chacune constituée d'un feuillet de matériau électriquement conducteur découpé, puis co-laminé avec un substrat diélectrique. De tels circuits imprimés sont utilisés par exemple pour la réalisation de contacts pour modules électroniques de carte à puce, d'antennes pour carte à puce, de circuits mixtes comprenant à la fois des contacts et une antenne, etc.

A titre d'illustration, si on prend l'exemple des cartes à puce, celles-ci sont généralement constituées d'un support rigide, par exemple en matière plastique, constituant l'essentiel de la carte, dans lequel est incorporé un module électronique fabriqué séparément. Ce module électronique comporte un circuit imprimé, généralement flexible, muni d'une puce (circuit intégré) et de moyens de connexion de la puce à un dispositif permettant de lire et/ou d'écrire des données dans la puce. Ces moyens de connexion -ou connecteurs- sont par exemple formés de contacts constitués de pistes métalliques conductrices affleurant sur le module électronique, en surface du support. Outre la nécessité d'avoir une excellente résistance mécanique et une excellente résistance à la corrosion des contacts, ainsi qu'une bonne conduction électrique entre la puce et les contacts d'une part et entre les contacts et un dispositif de lecture/écriture d'autre part, les fabricants de cartes à puce souhaitent assortir la couleur des contacts à la ou les couleurs(s) de la carte. A cet effet, les contacts sont généralement recouverts soit d'une couche d'or, pour obtenir une finition dorée, soit d'une couche d'argent ou de palladium, pour obtenir une finition argentée. Mais, ce type de finition pose des problèmes. Par exemple, le palladium est un métal relativement coûteux ; quant à l'or, il doit être déposé sur une couche de nickel qui, d'une part a des propriétés magnétiques présentant des inconvénients pour les applications en radiofréquences et/ou pour des applications nécessitant une absence de propriétés magnétiques, et d'autre part, est problématique dans le domaine médical si celui-ci doit être placé au contact ou à proximité de la peau, etc. Le document US2013/236742 divulgue un procédé de dépôt d'un alliage de bronze sur un circuit imprimé.

Un but de l'invention est de réaliser des circuits imprimés flexibles dans lesquels le palladium et/ou le nickel ne sont pas ou peu utilisés, tout en conservant des propriétés électriques et mécaniques appropriées pour leur utilisation notamment dans des modules à contacts pour carte à puce.

A cet effet, un procédé de dépôt d'un alliage de bronze blanc sur un circuit imprimé, est présenté ci-dessous. Celui-ci comprend notamment :
- la fourniture d'un substrat diélectrique comprenant une première et une deuxième faces principales, avec au moins un premier feuillet d'un premier matériau électriquement conducteur (par exemple du cuivre, de l'aluminium, ou un de leurs alliages, de l'acier, etc.) au moins sur la première face principale,
- au moins une opération de dépôt électrolytique d'au moins une couche d'au moins un deuxième matériau électriquement conducteur sur au moins une zone du premier feuillet.

En outre, dans ce procédé, ladite au moins une opération de dépôt électrolytique d'au moins une couche d'au moins un deuxième matériau électriquement conducteur comprend une opération de dépôt électrolytique d'une couche de bronze comprenant après dépôt 45 à 65%, avantageusement 45 à 62% et préférentiellement 45 à 50%, en poids de cuivre, 30 à 45%, et préférentiellement 40 à 45%, en poids d'étain et 2 à 11%, avantageusement 6 à 11%, en poids de zinc.

Ce procédé (ainsi que toutes les opérations décrites dans ce document) peut être mis en œuvre de rouleau à rouleau (« reel-to-reel » en anglais).

La couche de bronze remplace avantageusement une couche de palladium par exemple, sur une face visible d'une plage de contact. Elle peut éventuellement permettre également de ne pas déposer de nickel (alors que le nickel est indispensable en couche sous-jacente à une couche d'or par exemple). La couche de bronze est plus économique qu'une couche de palladium. L'absence de nickel est préférable pour les applications en radiofréquences et pour certaines applications médicales.

Le procédé mentionné ci-dessus comporte avantageusement l'une ou l'autre des caractéristiques suivantes considérées indépendamment les unes des autres ou en combinaison d'une ou plusieurs autres :
- il comprend une opération de finition au cours de laquelle un traitement de surface est réalisé après le dépôt de la couche de bronze, pour former par exemple une couche de protection comprenant un conservateur organique de soudabilité (« OSP » ou Organic Solderability Preservative en anglais) ou une monocouche autoassemblée (« SAM » ou Self-Assembled Monolayer en anglais) ;
- ce traitement de surface est réalisé directement (c'est-à-dire sans autre matériau entre la couche de protection et la couche de bronze) sur au moins une portion de ladite couche de bronze ;
- alternativement, si ladite au moins une opération de dépôt électrolytique d'au moins une couche d'au moins un deuxième matériau électriquement conducteur comprend également un dépôt électrolytique d'une couche superficielle comprenant au moins un élément compris dans la liste constituée de l'or, de l'argent, du palladium, du rhodium et du ruthénium ; le traitement de surface peut être réalisé directement sur au moins une portion de cette couche superficielle ;
- ladite au moins une opération de dépôt électrolytique d'au moins une couche d'au moins un deuxième matériau électriquement conducteur comprend également un dépôt électrolytique, sous forme d'une fine couche, de moins de 15 nanomètres d'épaisseur, d'au moins un élément compris dans la liste constituée de l'or, de l'argent, et du palladium.
- ladite au moins une opération de dépôt électrolytique d'au moins une couche d'au moins un deuxième matériau électriquement conducteur comprend une opération de dépôt électrolytique de la couche de bronze, ainsi qu'une opération de dépôt électrolytique d'une couche nickel et d'une couche de nickel-phosphore, préalablement au dépôt de la couche de bronze.

Selon un autre aspect, un circuit imprimé est décrit ci-dessous. Il comprend des plages de contact configurées pour former des contacts pour au moins un module de carte à puce. Ce circuit imprimé comprend alors
- sur l'une des faces principales du substrat diélectrique, un feuillet du premier matériau électriquement conducteur dont au moins une partie de la surface est recouverte d'un empilement de couches comprenant au moins une couche de nickel, une couche de nickel-phosphore et la couche de bronze ;

Ce circuit imprimé comprend éventuellement en outre l'une ou l'autre des caractéristiques suivantes considérées indépendamment les unes des autres ou en combinaison d'une ou plusieurs autres :
- il comprend des puits de connexion au fond desquels est disposé un empilement de couches comprenant au moins : une couche de nickel, une couche de nickel-phosphore, une couche superficielle comprenant au moins l'un des éléments suivants : or, argent, rhodium, ruthénium et palladium :
   - il comprend une fine couche d'or, d'argent ou de palladium avec une épaisseur inférieure ou égale à 15 nanomètres, sous-jacente à la couche de bronze et à la couche superficielle ;
   - il comprend sur l'autre des faces principales du substrat diélectrique, un deuxième feuillet du premier matériau électriquement conducteur dont au moins une partie de la surface est recouverte d'un empilement de couches comprenant au moins : une couche de nickel, une couche de nickel-phosphore, une couche de métal superficielle comprenant au moins l'un des éléments suivants : or, argent, palladium, rhodium et ruthénium ;
   - la couche de bronze a une épaisseur supérieure ou égale à 150 nanomètres et inférieure ou égale à 600 nanomètres.

D'autres caractéristiques et avantages de l'invention apparaîtront à la lecture de la description détaillée et des dessins annexés sur lesquels :
- FIG. 1 représente schématiquement en perspective une carte à puce comportant un exemple de module selon l'invention ;
- FIG. 2 représente schématiquement vue de dessus une portion d'un exemple de circuit imprimé selon l'invention, comprenant plusieurs connecteurs pour module de carte à puce ;
- FIG. 3 représente en coupe, partiellement et schématiquement, un exemple de circuit imprimé simple face pour un connecteur de module de carte à puce telle que celle représentée sur la figure 1 ;
- FIG. 4 représente en coupe, partiellement et schématiquement, un exemple de circuit imprimé double face pour un connecteur de module de carte à puce telle que celle représentée sur la figure 1 ;
- FIG. 5 représente en coupe, partiellement et schématiquement, un exemple de circuit imprimé double face tel que celui de la figure 4, sur lequel sont électrodéposées plusieurs couches ; ainsi que sa variante en simple face, si l'on fait abstraction des feuillets et couches situés sous les traits pointillés ;
- FIG. 6 représente en coupe, partiellement et schématiquement, un autre exemple de circuit imprimé double face tel que celui de la figure 4, sur lequel sont électrodéposées plusieurs couches ; ainsi que sa variante en simple face, si l'on fait abstraction des feuillets et couches situés sous les traits pointillés ;
- FIG. 7 représente en coupe, partiellement et schématiquement, encore un autre exemple de circuit imprimé double face tel que celui de la figure 4, sur lequel sont électrodéposées plusieurs couches ; ainsi que sa variante en simple face si l'on fait abstraction des feuillets et couches situés sous les traits pointillés ;
- FIG. 8 représente en coupe, partiellement et schématiquement, encore un autre exemple de circuit imprimé double face tel que celui de la figure 4, sur lequel sont électrodéposées plusieurs couches ; ainsi que sa variante en simple face si l'on fait abstraction des feuillets et couches situés sous les traits pointillés ;
- FIG. 9 représente en coupe, partiellement et schématiquement, un exemple de circuit imprimé simple face tel que celui de la figure 3, sur lequel sont électrodéposées plusieurs couches ; et
- FIG. 10 représente en coupe, partiellement et schématiquement, un autre exemple de circuit imprimé simple face tel que celui de la figure 3, sur lequel sont électrodéposées plusieurs couches.

Dans ce document, un exemple d'application du circuit imprimé selon l'invention est pris dans le domaine de la carte à puce, mais l'homme du métier saura, sans pour cela faire preuve d'activité inventive, transposer cet exemple à d'autres applications des circuits imprimés (des contacts pour prise USB, des antennes, des dispositifs pour des applications médicales tels que des capteurs de pression au contact de la peau, des bandelettes de détection du glucose ou d'autres composés dans le sang, des électrodes pour la réalisation d'encéphalogramme etc.).

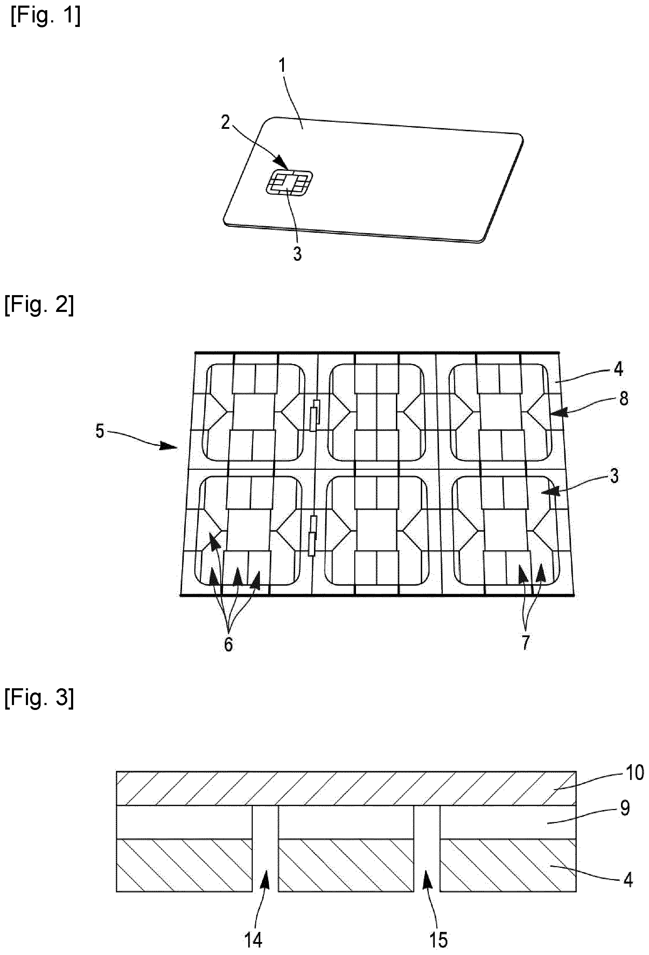

Selon un exemple d'application du circuit imprimé selon l'invention, illustré par la figure 1, une carte à puce 1 comporte un module 2 avec un connecteur 3. Selon cet exemple, la carte à puce 1 est une carte bancaire au format ID-1. Le module 2 est par exemple un module de type bancaire (aussi appelé module « EMV » pour Europay Mastercard Visa) répondant à la norme ISO 7810. Le module 2 est généralement réalisé sous forme d'un élément séparé qui est inséré dans une cavité ménagée dans la carte. Cet élément comporte un substrat diélectrique 4 (voir Fig. 2), dont l'épaisseur est comprise par exemple entre 25 et 150 micromètres (il est donc généralement flexible) de PET, de polyimide, de verre-epoxy, etc. Sur le substrat diélectrique 4 est réalisé le connecteur 3, auquel est postérieurement connectée une puce (nonreprésentée), par la face du substrat opposée à celle comportant le connecteur 3.

La figure 2 illustre ainsi un exemple de portion de circuit imprimé 5, avec six connecteurs 3. Chaque connecteur 3 comprend une plage de contacts 8 formée de plages conductrices 6. Dans l'exemple illustré ici, huit des plages conductrices 6 sont destinées à former les contacts électriques 7 (identifiés de C1 à C8 tels que définis par la norme ISO 7816-2)

Le connecteur 3 peut être formé à partir d'une structure simple face (avec un feuillet de matériau conducteur sur seulement une seule des faces principales d'un substrat diélectrique 4) ou d'une structure double face (avec un feuillet de matériau conducteur sur chacune des deux faces principales d'un substrat diélectrique 4).

Un exemple de structure simple face est illustré sur la figure 3. Cette structure simple face est par exemple réalisée selon le procédé suivant : on fournit un substrat diélectrique 4, que l'on enduit sur l'une de ses faces principales avec une couche d'adhésif 9 ; puis, le substrat diélectrique 4 muni de la couche d'adhésif 9 est perforé afin de réaliser des puits de connexion 14 et éventuellement une cavité 15 dans laquelle sera logée ultérieurement une puce ; le substrat diélectrique 4 muni de la couche d'adhésif 9 est ensuite complexé (laminé) avec un premier feuillet 10 d'un premier matériau conducteur tel qu'un feuillet de cuivre, d'aluminium, ou d'un de leurs alliages, ou encore d'acier, etc, avant de subir éventuellement une réticulation à chaud de la couche d'adhésif 9. Alternativement, il est possible d'utiliser directement un stratifié (« clad » en anglais), mais dans ce cas, les puits de connexion 14 et/ou de la cavité 15 sont formés par exemple à l'aide d'un laser configuré pour ne perforer que le substrat diélectrique 4. Dans tous les cas, Le fond des puits de connexion 14 et/ou de la cavité 15 est ainsi constitué d'une surface électriquement conductrice, sur laquelle pourront être électrodéposées éventuellement des couches de matériau conducteur, en vue d'une connexion électrique, par exemple à l'aide d'une technologie de connexion par fils conducteurs (« wire bonding » en anglais).

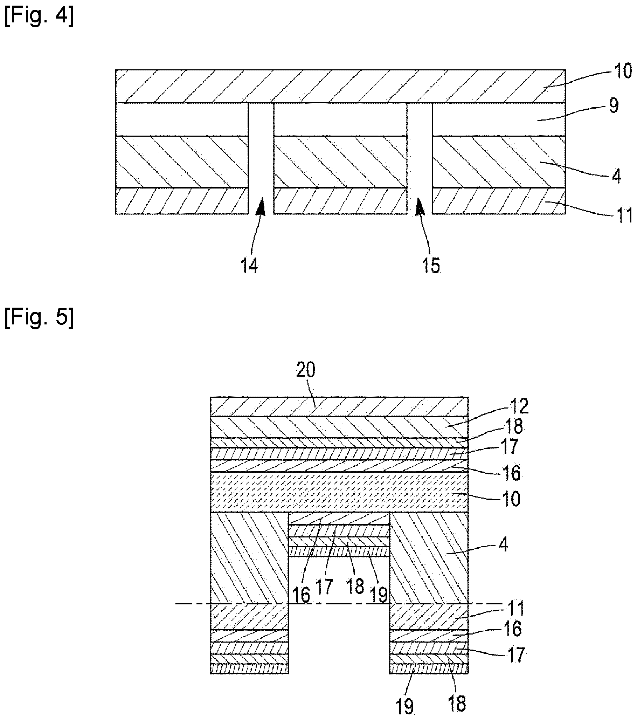

Un exemple de structure double face est illustré sur la figure 4. Cette structure double face est exemple réalisée selon le procédé suivant : on fournit un substrat diélectrique 4 supportant déjà, sur une première de ses faces principales (qui correspondra à la face arrière), un deuxième feuillet 11 d'un premier matériau conducteur tel qu'un feuillet de cuivre, d'aluminium, ou d'un de leurs alliages, ou encore d'acier, etc. ; il s'agit alors d'un stratifié par exemple ; on enduit l'autre de ses faces principales (qui correspondra à la face avant) avec une couche d'adhésif 9 ; puis, ce stratifié muni de la couche d'adhésif 9 est éventuellement perforé afin de réaliser des puits de connexion 14 et éventuellement une cavité 15 dans laquelle sera logée ultérieurement une puce ; le stratifié muni de la couche d'adhésif 9 est ensuite complexé (laminé) avec un premier feuillet 10de matériau conducteur (par exemple également constitué du même matériau conducteur que le premier matériau conducteur, même si les épaisseurs respectives des premier 10 et deuxième 11 feuillets peuvent être différentes ; on notera cependant que les premier 10 et deuxième 11 feuillets peuvent être constitués de matériaux électriquement conducteurs différents). Le fond des puits de connexion 14 et/ou de la cavité 15 est ainsi constitué d'une surface électriquement conductrice, sur laquelle pourront être électrodéposées éventuellement des couches de matériau conducteur, en vue d'une connexion électrique, par exemple à l'aide d'une technologie de connexion par fils conducteurs (« wire bonding » en anglais). Alternativement, il est possible d'utiliser directement un stratifié double face (« double-sided clad » en anglais), mais dans ce cas, les puits de connexion 14 et/ou de la cavité 15 sont formés par exemple à l'aide d'un laser configuré pour ne perforer que le substrat diélectrique 4 et le deuxième feuillet 11 de matériau électriquement conducteur.

Par exemple, comme représenté en coupe sur les figures 5 à 10, un connecteur 3 (c'est-à-dire essentiellement un module 2 sans puce) possède une structure multicouche formée du substrat diélectrique 4, d'une couche d'adhésif 9 (optionnelle et non représentée sur les figures 5 à 10), et d'un premier 10, et éventuellement d'un deuxième 11, feuillets constitués d'un premier matériau électriquement conducteur sur lequel est déposée par voie électrochimique au moins une couche 12 d'au moins un deuxième matériau électriquement conducteur. Par exemple, le premier matériau électriquement conducteur est constitué de cuivre ou d'un alliage de cuivre. La couche de deuxième matériau électriquement conducteur 12 est constituée de bronze comprenant après dépôt 45 à 65%, avantageusement 45 à 62% et préférentiellement 45 à 50%, en poids de cuivre, 30 à 45%, et préférentiellement 40 à 45%, en poids d'étain et 2 à 11%, avantageusement 6 à 11%, en poids de zinc. Les compositions respectives de la couche de bronze 12 ne sont pas nécessairement les mêmes sur le premier 10 et le deuxième feuillet 11. La composition de la couche de bronze 12 déposée sur le deuxième feuillet 11 peut en effet être déterminée par le souhait d'obtenir une meilleure soudabilité sur celle-ci. La couche de bronze 12 est déposée par exemple à partir d'un bain Miralloy^{®} commercialisé par la société Umicore^{®}, à une température voisine ou égale à 60°C, avec une densité de courant de 4A/dm². D'autres matériaux peuvent être déposés par voie électrochimique entre le premier matériau électriquement conducteur et la couche de bronze 12, voire au-dessus de celle-ci.

La couche de bronze 12 peut être utilisée, par exemple, soit pour remplacer, au moins sur une face, des métaux nobles ou précieux (or, argent, palladium) dans une structure multicouche telle que celle utilisée pour la réalisation de modules de carte à puce, soit pour remplacer, au moins sur une face, le nickel dans une structure multicouche telle que celle utilisée dans des dispositifs visant des applications médicales ou en radiofréquences par exemple.

Sur l'exemple illustré sur la figure 5, la structure multicouche est une structure double face. Elle comporte un substrat diélectrique 4 dont la nature a déjà été mentionnée plus haut. Ce substrat diélectrique 4 est perforé par exemple pour former des puits de connexion 14 permettant de connecter, chacun respectivement, électriquement une puce située sur une face arrière (« rear side » ou « bonding side » en anglais) à des plages de contact 8 situées en face avant (« front side » ou « contact side » en anglais). Ce substrat diélectrique 4 comporte sur chacune de ses faces principales, respectivement un premier 10 et d'un deuxième 11 feuillets tous deux formés d'un premier matériau électriquement conducteur, par exemple du cuivre ou un alliage de cuivre (alternativement, le premier matériau électriquement conducteur peut être de l'aluminium, ou un de ses alliages, de l'acier, etc.).

Plusieurs couches de matériaux électriquement conducteurs sont déposées par voie électrochimique sur au moins certaines zones de la surface libre de chacun des deux feuillets 10, 11 de premier matériau électriquement conducteur. Sur l'exemple illustré par la figure 5, la face arrière reçoit ainsi une couche de nickel 16, une couche de nickel-phosphore 17, une fine couche 18 sous forme de « flash » ou amorce de l'un des métaux choisis parmi l'or, l'argent et le palladium, et enfin une couche superficielle 19 comprenant au moins l'un des métaux choisis parmi l'or, l'argent, le palladium, le rhodium le ruthénium. Sur la face avant, le circuit imprimé reçoit successivement une couche de nickel 16, une couche de nickel-phosphore 17, une fine couche 18 sous forme de « flash » ou amorce d'or et une couche bronze 12 dont la composition est mentionnée plus haut. De manière optionnelle, la face avant subit un traitement de protection et est donc recouverte d'une couche de protection 20.

Le tableau ci-dessous, résume des exemples d'épaisseurs caractéristiques de chacune des couches de la structure illustrée par la figure 5.

| Face avant | Face arrière |
|---|---|
| Adhésif 9 : 10 à 25 µm | |
| Feuillet de cuivre 10 : 12 à 70 micromètres | Feuillet de cuivre 11 : 12 à 70 micromètres |
| Couche de nickel 16 : 0,5 à 6 micromètres | Couche de nickel 16 : 1 à 15 micromètres |
| Couche de nickel-Phosphore 17 : 0,05 à 0,6 micromètres | Couche de nickel-Phosphore 17 : 0,05-0,6 micromètres |
| Fine couche 18 : Or ou Argent ou Palladium : 0 à 15 nanomètres | Fine couche 18 : Or ou Argent ou Palladium : 0 à 15 nanomètres |
| Couche de bronze 12 : 100 nanomètres à 3 micromètres | Couche superficielle 19 contenant au moins l'un des éléments parmi : Au, Ag, Pd, Rh ou Ru : 10 nanomètres à 1 micromètres (jusqu'à 3 micromètres pour Ag) |
| Couche de protection 20 (optionnelle) | |

Selon cet exemple, l'empilement des couches sur la face arrière est le même que ce soit au fond des puits de connexion 14 ou sur la deuxième face principale du substrat.

Selon une variante du mode de réalisation illustré par la figure 5, la face arrière du substrat diélectrique 4 est laissée nue (sans le deuxième feuillet 11 du premier matériau électriquement conducteur et les couches (16 à 19) électrodéposées sur celle-ci) ; par contre, au fond des puits de connexion 14, on retrouve un empilement comprenant une couche de nickel 16, une couche de nickel-phosphore 17, une fine couche 18 sous forme de « flash » ou amorce de l'un des métaux choisis parmi l'or, l'argent et le palladium, et enfin une couche superficielle 19 comprenant au moins l'un des métaux choisis parmi l'or, l'argent le rhodium le ruthénium et le palladium. Il s'agit alors d'une structure simple face.

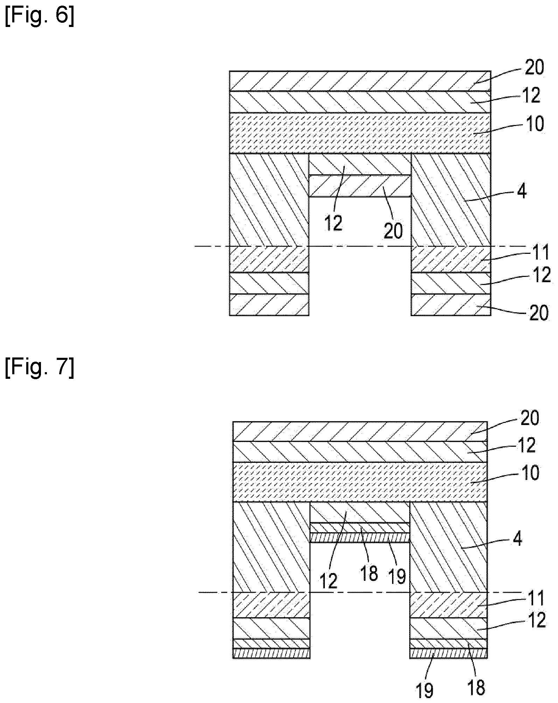

Sur l'exemple illustré sur la figure 6, la structure multicouche est une structure double face. Elle comporte un substrat diélectrique 4 tel que mentionné plus haut. Comme dans l'exemple précédent, le substrat diélectrique 4 est perforé et comporte sur chacune de ses faces principales, respectivement un premier 10 et d'un deuxième 11 feuillets, tous deux formés d'un premier matériau électriquement conducteur constitué, par exemple, comme précédemment du cuivre ou un alliage de cuivre. Les premier 10 et deuxième 11 feuillets sont attachés au substrat diélectrique 4 de l'une des manières décrites ci-dessus par exemple.

Plusieurs couches de matériaux électriquement conducteurs sont déposées par voie électrochimique sur au moins certaines zones de la surface libre de chacun des deux feuillets 10, 11 de premier matériau électriquement conducteur. Sur l'exemple illustré par la figure 6, les faces avant et arrière reçoivent une couche de bronze 12. De manière optionnelle, les faces avant et arrière reçoivent une couche de protection 20. La couche de protection 20 est optionnelle et peut être déposée sur une seule des deux faces ou sur les deux faces. Ce mode de réalisation est notamment avantageux pour remplacer le nickel et le palladium sur la face avant. Il est également avantageux au niveau des coûts de production car, il y a un nombre réduit d'opérations de dépôt électrolytique.

Le tableau ci-dessous, résume des exemples d'épaisseurs caractéristiques de chacune des couches de la structure illustrée par la figure 6.

| Face avant | Face arrière |
|---|---|
| Adhésif 9 : 10 à 25 micromètres | |
| Feuillet de cuivre 10 : 12 à 70 micromètres | Feuillet de cuivre 11 : 12 à 70 micromètres |
| Couche de bronze 12 : 100 nanomètres à 3 micromètres | Couche de bronze 12 : 50 nanomètres à 6 micromètres |
| Couche de protection 20 (optionnelle) | Couche de protection 20 (optionnelle) |

Selon une variante du mode de réalisation illustré par la figure 6, la face arrière du substrat diélectrique 4 est laissée nue et au fond des puits de connexion 14, on retrouve un empilement comprenant la couche de bronze 12 et la couche optionnelle de post traitement 20. Il s'agit alors d'une structure simple face.

Sur l'exemple illustré sur la figure 7, la structure multicouche est une structure double face. Elle comporte un substrat diélectrique 4 tel que mentionné plus haut. Comme dans les exemples précédents, le substrat diélectrique 4 est perforé et comporte sur chacune de ses faces principales, respectivement un premier 10 et d'un deuxième 11 feuillets, tous deux formés d'un premier matériau électriquement conducteur constitué, par exemple, comme précédemment du cuivre ou un alliage de cuivre. Les premier 10 et deuxième 11 feuillets sont attachés au substrat diélectrique 4, de l'une des manières décrites ci-dessus par exemple.

Plusieurs couches de matériaux électriquement conducteurs sont déposées par voie électrochimique sur au moins certaines zones de la surface libre de chacun des deux feuillets 10, 11 de premier matériau électriquement conducteur. Sur l'exemple illustré par la figure 7, les faces avant et arrière reçoivent une couche de bronze 12. De manière optionnelle, la face avant reçoit une couche de protection 20. Ce mode de réalisation est notamment avantageux pour remplacer le nickel et le palladium sur la face avant. Optionnellement, la face arrière reçoit, sur la couche de bronze 12, au moins une couche comprenant au moins un métal de la liste suivante : or, argent, palladium, rhodium, ruthénium.

Le tableau ci-dessous, résume des exemples d'épaisseurs caractéristiques de chacune des couches de la structure illustrée par la figure 7.

| Face avant | Face arrière de connexion |
|---|---|
| Adhésif : 10 à 25 micromètres | |
| Feuillet de cuivre 10 : 12 à 70 micromètres | Feuillet de cuivre 11 : 12 à 70 micromètres |
| Couche de bronze 12 : 100 nanomètres à 3 micromètres | Couche de bronze 12 : 50 nanomètres à 6 micromètres |
| Couche de protection 20 (optionnelle) | Fine couche 18 Or ou Argent ou Palladium : 0 à 15 nanomètres (Optionnel) |
| | Couche superficielle 19 contenant Au, Ag, Pd, Rh ou Ru : 10 nanomètres à 1micromètre. (jusqu'à 3 micromètres pour Ag) (Optionnel) |

Selon une variante du mode de réalisation illustré par la figure 7, la face arrière du substrat diélectrique est laissée nue (sans le deuxième feuillet 11 du premier matériau électriquement conducteur et les couches (18 à 19) électrodéposées sur celle-ci) ; par contre, au fond des puits de connexion, on retrouve un empilement comprenant une couche de bronze 12, une fine couche 18 optionnelle sous forme de « flash » ou amorce de l'un des métaux choisis parmi l'or, l'argent et le palladium, et enfin au moins une couche 19 comprenant un métal ou un composé de la liste suivante : or, argent, palladium, rhodium ruthénium. Il s'agit alors d'une structure simple face.

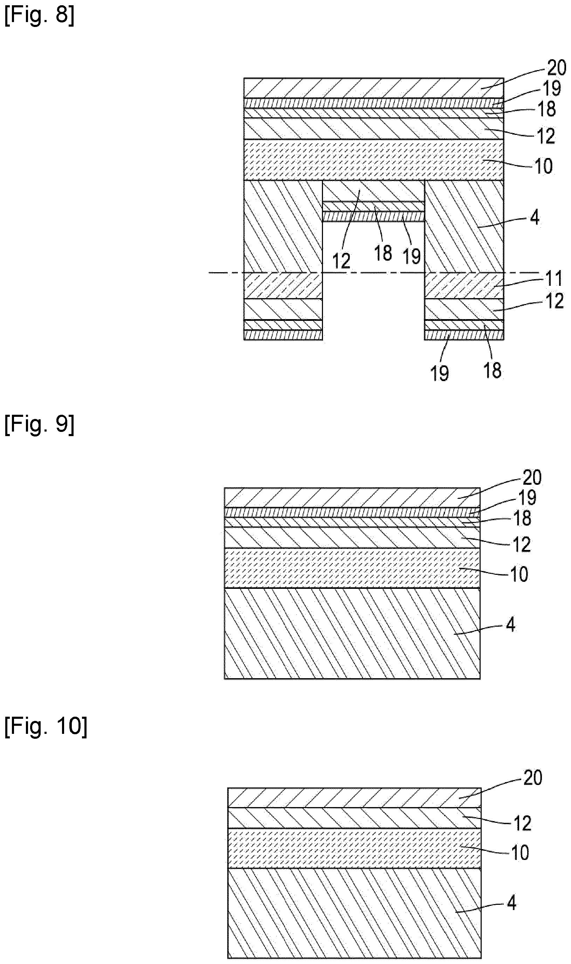

Sur l'exemple illustré sur la figure 8, la structure multicouche est une structure double face. Elle diffère de celle décrite en relation avec la figure 7 essentiellement par le fait que, sur la face avant, la couche de bronze 12 est recouverte d'une fine couche 18 optionnelle sous forme de « flash » ou amorce de l'un des métaux choisis parmi l'or, l'argent et le palladium, elle-même recouverte d'au moins une couche 19 comprenant un métal de la liste suivante : or, argent, palladium, ruthénium, rhodium. De manière optionnelle, la face avant reçoit ensuite une couche de protection 20.

Le tableau ci-dessous, résume des exemples d'épaisseurs caractéristiques de chacune des couches de la structure illustrée par la figure 8.

| Face avant | Face arrière |
|---|---|
| Adhésif : 10 à 25 micromètres | |
| Feuillet de cuivre 10 : 12 à 70 micromètres | Feuillet de cuivre 11 : 12 à 70 micromètres |
| Couche de bronze 12 : 100 nanomètres à 3 micromètres | Couche de bronze 12 : 50 nanomètres à 6 micromètres |
| Fine couche 18 : Or ou Argent ou Palladium 0 à 15 nanomètres (Optionnel) | Fine couche 18 : Or ou Argent ou Palladium 0 à 15 nanomètres (Optionnel) |
| Couche superficielle 19 contenant Au, Ag, Pd, Rh ou Ru : 10 nanomètres à 1micromètres | Couche superficielle 19 contenant Au, Ag, Pd, Rh ou Ru : 10 nanomètres à 1micromètre (jusqu'à 3 micromètres pour Ag) (Optionnel) |
| Couche de protection 20 (optionnelle) | |

Comme précédemment, on obtient en variante une structure simple face en ne recouvrant pas la deuxième face principale (côté face arrière) du substrat diélectrique par un deuxième feuillet 11 constitué du premier matériau conducteur et des éventuelles couches déposées sur celui-ci.

Sur l'exemple illustré sur la figure 9, la structure multicouche est une structure simple face. Elle comporte un substrat diélectrique 4 tel que mentionné plus haut. Du côté de la face avant, le premier feuillet 10 constitué du premier matériau électriquement conducteur est attaché au substrat diélectrique 4 de l'une des manières décrites ci-dessus.

Plusieurs couches de matériaux électriquement conducteurs sont déposées par voie électrochimique sur au moins certaines zones de la surface libre de la du premier feuillet 10. Sur l'exemple illustré par la figure 9, la face avant reçoit une couche de bronze 12, puis éventuellement une fine couche 18 sous forme de « flash » ou amorce de l'un des métaux choisis parmi l'or, l'argent et le palladium, et enfin au moins une couche superficielle 19 comprenant un métal de la liste suivante : or, argent, palladium rhodium, ruthénium. De manière optionnelle, la face avant reçoit ensuite une couche de protection 20.

Le tableau ci-dessous, résume des exemples d'épaisseurs caractéristiques de chacune des couches de la structure illustrée par la figure 9.

| Face avant |
|---|
| Adhésif : 10 à 25 micromètres |
| Feuillet de cuivre 10 : 12 à 70 micromètres |
| Couche de bronze 12 : 100 nanomètres à 3 micromètres |
| Fine couche 18 : Or ou Argent ou Palladium : 0 à 15 nanomètres (Optionnel) |
| Couche superficielle 19 contenant Au, Ag, Pd, Rh ou Ru : |
| 10 nanomètres à 1 micromètre (jusqu'à 3 micromètres pour Ag) |
| Couche de protection 20 (optionnelle) |

Sur l'exemple illustré sur la figure 10, la structure multicouche est une structure simple face. Elle diffère essentiellement de celle précédemment décrite par le fait qu'elle ne comporte pas de fine couche 18 sous forme de « flash » ou amorce de l'un des métaux choisis parmi l'or, l'argent et le palladium, ni de couche superficielle 19 comprenant un métal de la liste suivante : or, argent, palladium, rhodium, ruthénium.

Par contre, de manière optionnelle, la face avant peut recevoir ensuite une couche de protection 20.

Le tableau ci-dessous, résume des exemples d'épaisseurs caractéristiques de chacune des couches de la structure illustrée par la figure 10.

| Face avant |
|---|
| Adhésif : 10 à 25 micromètres |
| Feuillet de cuivre 10 : 12 à 70 micromètres |
| Couche de bronze 12 : 100 nanomètres à 3 micromètres |
| Couche de protection 20 (optionnelle) |

Dans les modes de réalisation présentés ci-dessus avec leurs variantes, lorsqu'un un traitement de protection 20 est réalisé, celui-ci peut correspondre, de manière non exhaustive, au passage dans ;
- un bain de conservateur organique de soudabilité, tel que du benzotriazole ou un imidazole (par exemple un alkyl benzimidazole, un aryl benzimidazole, etc.) ;
- un bain adapté pour former une mono-couche auto-organisée, tel qu'un mélange d'éther du polyéthylèneglycol et de propylèneglycol, ou encore un mélange d'octylphénoxyéthanol et d'octadécane-1-thiol ou encore du Monooléate de polyoxyéthylène de sorbitane (Polysorbate 80, numéro C.A.S 9005-65-6) , ou encore un mélange d'Alcools (C12-18) éthoxylés propoxylés (numéro C.A.S 69227-21-0) avec de l'Éther de lauryl poly(oxyéthylène) (numéro C.A.S 9002-92-0) et du 1-octadécanethiol (C.A.S 2885-00-9)

Par exemple un module de carte à puce comprenant un empilement constitué d'un diélectrique 4 recouvert d'un feuillet de cuivre 10 sur lequel sont électrodéposées une couche de nickel 16, une couche de nickel phosphore 17, un flash d'or 18 et une couche de bronze 12 de 0,5 micromètre comprenant 45 à 50% en poids de cuivre, 40 à 45% en poids d'étain et 6 à 11% en poids de zinc (structure de la figure 5), présente une résistance de contact (CRM) inférieure à 500mOhm avant et après avoir été soumis à un test de brouillard salin de 24h, conformément à la norme ISO 10 373.

## Revendications

1. Procédé de dépôt d'un alliage de bronze sur un circuit imprimé (5),
comprenant :
la fourniture d'un substrat diélectrique (4) comprenant une première et une deuxième faces principales, avec au moins un premier feuillet (10) d'un premier matériau électriquement conducteur au moins sur la première face principale,
au moins une opération de dépôt électrolytique d'au moins une couche (12) d'au moins un deuxième matériau électriquement conducteur sur au moins une zone du premier feuillet (10),
**caractérisé par le fait que** ladite au moins une opération de dépôt électrolytique d'au moins une couche (12) d'au moins un deuxième matériau électriquement conducteur comprend une opération de dépôt électrolytique d'une couche de bronze comprenant après dépôt 45 à 65% en poids de cuivre, 30 à 45% en poids d'étain et 2 à 11% en poids de zinc.

2. Procédé selon la revendication 1, comprenant une opération de finition au cours de laquelle un traitement de surface est réalisé après le dépôt de la couche de bronze (12).

3. Procédé selon la revendication 2, dans lequel l'opération de finition comporte l'application d'une couche de protection (20) comprenant un conservateur organique de soudabilité.

4. Procédé selon la revendication 2, dans lequel l'opération de finition comporte l'application d'une couche de protection (20) comprenant une monocouche autoassemblée.

5. Procédé selon l'une des revendications 2 à 4, dans lequel le traitement de surface est réalisé directement sur au moins une portion de ladite couche de bronze (12).

6. Procédé selon l'une des revendications 1 et 2, dans lequel ladite au moins une opération de dépôt électrolytique d'au moins une couche d'au moins un deuxième matériau électriquement conducteur comprend également un dépôt électrolytique d'une couche superficielle (19) comprenant au moins un élément compris dans la liste constituée de l'or, de l'argent, du palladium, ruthénium, rhodium.

7. Procédé selon l'une des revendications 2 à 4, chacune prise en combinaison avec la revendication 6, dans lequel le traitement de surface est réalisé directement sur au moins une portion de ladite couche superficielle (19).

8. Procédé selon la revendication 6 ou 7, dans lequel ladite au moins une opération de dépôt électrolytique d'au moins une couche d'au moins un deuxième matériau électriquement conducteur comprend également un dépôt électrolytique, sous forme d'une fine couche (18), de moins de 15 nanomètres d'épaisseur, d'au moins un élément compris dans la liste constituée de l'or, de l'argent, du palladium.

9. Procédé selon l'une des revendications précédentes, dans lequel ladite au moins une opération de dépôt électrolytique d'au moins une couche d'au moins un deuxième matériau électriquement conducteur comprend, préalablement au dépôt de la couche de bronze (12), une opération de dépôt électrolytique d'une couche nickel (16) et d'une couche de nickel-phosphore (17).

10. Circuit imprimé (5) obtenu par le procédé selon l'une des revendications précédentes, comprenant des plages de contact (7) configurées pour former des contacts pour au moins un module (2) de carte à puce, ce circuit imprimé (5) comprenant sur l'une des faces principales du substrat diélectrique (4), le premier feuillet (10) d'un premier matériau électriquement conducteur dont au moins une partie de la surface est recouverte d'un empilement de couches comprenant au moins : une couche de nickel (16), une couche de nickel-phosphore (17), la couche de bronze (12).

11. Circuit imprimé (5) selon la revendication 10, comprenant des puits de connexion (14) au fond desquels est disposé un empilement de couches comprenant au moins : une couche de nickel (16), une couche de nickel-phosphore (17), une couche superficielle (19) comprenant au moins l'un des éléments suivants : or, argent, rhodium, ruthénium et palladium.

12. Circuit imprimé selon la revendication 11, comprenant en outre une fine couche (18) d'or, d'argent ou de palladium avec une épaisseur inférieure ou égale à 15 nanomètres, sous-jacente à la couche de bronze (12) et à la couche superficielle (19).

13. Circuit imprimé (5) selon l'une des revendications 10 à 12, comprenant sur l'autre des faces principales du substrat diélectrique un deuxième feuillet (11) d'un premier matériau électriquement conducteur dont au moins une partie de la surface est recouverte d'un empilement de couches comprenant au moins : une couche de nickel (16), une couche de nickel-phosphore (17), une couche superficielle (19) comprenant au moins l'un des éléments suivants : or, argent, rhodium, ruthénium et palladium.

14. Circuit imprimé (5) selon l'une des revendications 10 à 12, dans lequel la couche de bronze a une épaisseur supérieure ou égale à 150 nanomètres et inférieure ou égale à 600 nanomètres.

## Patentansprüche

1. Verfahren zum Aufbringen einer Bronzelegierung auf eine Leiterplatte (5),
umfassend:
Bereitstellung eines dielektrischen Substrats (4) mit einer ersten und einer zweiten Hauptfläche, mit mindestens einem ersten Blatt (10) aus einem ersten elektrisch leitfähigen Material zumindest auf der ersten Hauptfläche,
mindestens einen Vorgang des elektrolytischen Abscheidens mindestens einer Schicht (12) aus mindestens einem zweiten elektrisch leitfähigen Material auf mindestens einem Bereich des ersten Blattes (10),
**dadurch gekennzeichnet, dass** der mindestens eine Vorgang des elektrolytischen Abscheidens mindestens einer Schicht (12) aus mindestens einem zweiten elektrisch leitenden Material einen Vorgang des elektrolytischen Abscheidens einer Bronzeschicht umfasst, die nach dem Abscheiden 45 bis 65 Gew.-% Kupfer, 30 bis 45 Gew.-% Zinn und 2 bis 11 Gew.-% Zink umfasst.

2. Verfahren nach Anspruch 1, das einen Endbearbeitungsschritt umfasst, bei dem nach dem Aufbringen der Bronzeschicht (12) eine Oberflächenbehandlung durchgeführt wird.

3. Verfahren nach Anspruch 2, wobei der Endbearbeitungsschritt das Aufbringen einer Schutzschicht (20) umfasst, die ein organisches Lötbarkeitskonservierungsmittel umfasst.

4. Verfahren nach Anspruch 2, wobei der Endbearbeitungsvorgang das Aufbringen einer Schutzschicht (20) umfasst, die eine selbstorganisierte Monoschicht umfasst.

5. Verfahren nach einem der Ansprüche 2 bis 4, wobei die Oberflächenbehandlung direkt auf mindestens einem Abschnitt der Bronzeschicht (12) durchgeführt wird.

6. Verfahren nach einem der Ansprüche 1 und 2, wobei der mindestens eine Vorgang der elektrolytischen Abscheidens mindestens einer Schicht aus mindestens einem zweiten elektrisch leitenden Material auch das galvanische Abscheiden einer Oberflächenschicht (19) umfasst, die mindestens ein Element aus der Liste umfasst, die aus Gold, Silber, Palladium, Ruthenium, Rhodium besteht.

7. Verfahren nach einem der Ansprüche 2 bis 4, jeweils in Kombination mit Anspruch 6, wobei die Oberflächenbehandlung direkt auf mindestens einem Teil der elektrolytisch abgeschiedenen Oberflächenschicht (19) durchgeführt wird.

8. Verfahren nach Anspruch 6 oder 7, wobei der mindestens eine Vorgang der elektrolytischen Abscheidung mindestens einer Schicht mindestens eines zweiten elektrisch leitenden Materials auch die elektrolytische Abscheidung mindestens eines Elements aus der Liste bestehend aus Gold, Silber, Palladium in Form einer dünnen Schicht (18) mit einer Dicke von weniger als 15 Nanometern umfasst.

9. Verfahren nach einem der vorhergehenden Ansprüche, wobei der mindestens eine Vorgang des elektrolytischen Abscheidens mindestens einer Schicht aus mindestens einem zweiten elektrisch leitenden Material vor dem Abscheiden der Bronzeschicht (12) einen Vorgang des elektrolytischen Abscheidens einer Nickelschicht (16) und einer Nickel-Phosphor-Schicht (17) umfasst.

10. Gedruckte Schaltung (5), die durch das Verfahren nach einem der vorhergehenden Ansprüche erhalten wird, mit Kontaktflächen (7), die so gestaltet sind, dass sie Kontakte für mindestens ein Chipkartenmodul (2) bilden, wobei diese gedruckte Schaltung (5) auf einer der Hauptflächen des dielektrischen Substrats (4) das erste Blatt (10) aus einem ersten elektrisch leitenden Material umfasst, von dem mindestens ein Teil der Oberfläche mit einem Stapel von Schichten bedeckt ist, die mindestens : eine Nickelschicht (16), eine Nickel-Phosphor-Schicht (17), die Bronzeschicht (12).

11. Gedruckte Schaltung (5) nach Anspruch 10, mit Verbindungsschächten (14), an deren Boden ein Schichtstapel angeordnet ist, der mindestens Folgendes umfasst: eine Nickelschicht (16), eine Nickel-Phosphor-Schicht (17), eine Oberflächenschicht (19), die mindestens eines der folgenden Elemente umfasst: Gold, Silber, Rhodium, Ruthenium und Palladium.

12. Gedruckte Schaltung nach Anspruch 11, die außerdem eine dünne Schicht (18) aus Gold, Silber oder Palladium mit einer Dicke von 15 Nanometern oder weniger zwischen der Bronzeschicht (12) und der Schicht (19) umfasst.

13. Gedruckte Schaltung (5) nach einem der Ansprüche 10 bis 12, die auf der anderen der Hauptflächen des dielektrischen Substrats ein zweites Blatt (11) aus einem ersten elektrisch leitenden Material umfasst, bei dem mindestens ein Teil der Oberfläche mit einem Stapel von Schichten bedeckt ist, der mindestens Folgendes umfasst: eine Nickelschicht (16), eine Nickel-Phosphor-Schicht (17), eine Oberflächenschicht (19), die mindestens eines der folgenden Elemente umfasst: Gold, Silber, Rhodium, Ruthenium und Palladium.

14. Gedruckte Schaltung (5) nach einem der Ansprüche 10 bis 12, wobei die Bronzeschicht eine Dicke von 150 Nanometern oder mehr und 600 Nanometern oder weniger aufweist.

## Claims

1. Process for depositing a bronze alloy on a printed circuit (5), comprising:
providing a dielectric substrate (4) comprising first and second main faces, with at least a first sheet (10) of a first electrically conductive material on at least the first main face,
at least one operation of electrolytic deposition of at least one layer (12) of at least one second electrically conductive material on at least one zone of the first sheet (10),
**characterized in that** said at least one operation of electrolytic deposition of at least one layer (12) of at least one second electrically conductive material comprises an operation of electrolytic deposition of a bronze layer comprising, after deposition, 45 to 65% by weight of copper, 30 to 45% by weight of tin and 2 to 11 % by weight of zinc.

2. Process according to claim 1, comprising a finishing operation during which a surface treatment is carried out after the bronze layer (12) has been deposited.

3. Process according to claim 2, in which the finishing operation comprises the application of a protective layer (20) comprising an organic preservative of solderability.

4. Process according to claim 2, wherein the finishing operation comprises the application of a protective layer (20) comprising a self-assembled monolayer.

5. Process according to one of claims 2 to 4, in which the surface treatment is carried out directly on at least a portion of the said bronze layer (12).

6. Process according to one of claims 1 and 2, in which said at least one operation of electrolytic deposition of at least one layer of at least one second electrically conductive material also comprises electrolytic deposition of a surface layer (19) comprising at least one element from the list consisting of gold, silver, palladium, ruthenium and rhodium.

7. Process according to one of claims 2 to 4, each taken in combination with claim 6, wherein the surface treatment is carried out directly on at least a portion of said surface layer (19).

8. Process according to claim 6 or 7, in which said at least one operation of electrolytic deposition of at least one layer of at least one second electrically conductive material also comprises electrolytic deposition, in the form of a thin layer (18), less than 15 nanometers thick, of at least one element included in the list consisting of gold, silver and palladium.

9. Process according to one of the preceding claims, wherein said at least one operation of electrolytic deposition of at least one layer of at least one second electrically conductive material comprises, prior to the deposition of the bronze layer (12), an operation of electrolytic deposition of a nickel layer (16) and of a nickel-phosphorus layer (17).

10. Printed circuit (5) obtained by the process according to one of the preceding claims, comprising contact areas (7) configured to form contacts for at least one chip card module (2), this printed circuit (5) comprising, on one of the main faces of the dielectric substrate (4), the first sheet (10) of a first electrically conductive material, at least part of the surface of which is covered with a stack of layers comprising at least : a nickel layer (16), a nickel-phosphorus layer (17), the bronze layer (12).

11. Printed circuit (5) according to claim 10, comprising connection wells (14) at the bottom of which is arranged a stack of layers comprising at least: a nickel layer (16), a nickel-phosphorus layer (17), a surface layer (19) comprising at least one of the following elements: gold, silver, rhodium, ruthenium and palladium.

12. Printed circuit according to claim 11, further comprising a thin layer (18) of gold, silver or palladium with a thickness less than or equal to 15 nanometers, between the bronze layer (12) and the layer (19).

13. Printed circuit (5) according to one of claims 10 to 12, comprising, on the other of the main faces of the dielectric substrate, a second sheet (11) of a first electrically conductive material, at least part of the surface of which is covered with a stack of layers comprising at least: a nickel layer (16), a nickel-phosphorus layer (17), a surface layer (19) comprising at least one of the following elements: gold, silver, rhodium, ruthenium and palladium.

14. Printed circuit board (5) according to one of claims 10 to 12, wherein the bronze layer has a thickness greater than or equal to 150 nanometers and less than or equal to 600 nanometers.
